Europäisches Patentamt

European Patent Office

Office européen des brevets

(19)

(11) Publication number:

0 373 723
A1

# (12) EUROPEAN PATENT APPLICATION

(21) Application number: 89203161.8

(22) Date of filing: 12.12.89

(51) Int. Cl.5: H01L 21/322, H01L 21/336, H01L 21/82

(30) Priority: 16.12.88 IT 662788

(43) Date of publication of application:
20.06.90 Bulletin 90/25

(84) Designated Contracting States:
DE FR GB NL

(71) Applicant: SGS-THOMSON
MICROELECTRONICS s.r.l.
Via C. Olivetti, 2
I-20041 Agrate Brianza Milano(IT)

(72) Inventor: Magro, Carmelo
Via Guglielmino 16
I-95125 Catania CT(IT)
Inventor: Barbarino, Eleonora
Via Zangri 3
I-05030 Gravina Di Catania CT(IT)
Inventor: Pulvirenti, Antonino
Via Marconi 101
I-95030 Gravina Di Catania CT(IT)

(74) Representative: Arena, Giovanni
Viale Certosa 135
I-20151 Milano(IT)

(54) Method for manufacturing a MOS semiconductor device making use of a "gettering" treatment with improved characteristics, and MOS semiconductor devices obtained thereby.

(57) Immediately after the gate oxidation step the reverse side of the silicon wafers is chemically etched in order to remove the silicon dioxide formed thereon, and is then covered with a layer of polycrystalline silicon during the step normally envisaged for the deposition of polycrystalline silicon on the front of the wafer to form the gate of MOS devices.

FIG. 8B

EP 0 373 723 A1

# METHOD FOR MANUFACTURING A MOS SEMICONDUCTOR DEVICE MAKING USE OF A "GETTERING" TREATMENT WITH IMPROVED CHARACTERISTICS, AND MOS SEMICONDUCTOR DEVICES OBTAINED THEREBY.

This invention concerns a method for manufacturing MOS semiconductor devices making use of a "gettering" treatment with improved characteristics, and the MOS semiconductor devices obtained thereby.

In the manufacture of semiconductor devices it is the usual practice, during one step of the process, to subject the reverse side of the wafers to a "gettering" treatment in order to trap any impurities which may be present in the body of the wafers and consequently avoid the occurrence of undesired phenomena of leakage in the junctions obtained at the end of the process, with all the problems related thereto.

There are various known gettering methods: by depositing phosphorus (and subsequent annealing), by "internal gettering", by depositing a film of silicon nitride, polycrystalline silicon, etc.

With regard to the method consisting of depositing a film of polycrystalline silicon, this is mainly used by the various manufacturers of silicon substrates in order to minimize the crystalline defects in the epitaxial layers to be subsequently grown on them. In the case of the manufacture of MOS devices such possibility of using substrates "gettered" with polycrystalline silicon film does not prove to be applicable since, after the preliminary thermal treatments forming part of the process for manufacturing the MOS devices, the polycrystalline silicon film would be oxidated and consequently eliminated.

The gettering treatment most commonly used in manufacturing MOS devices is by deposition of phosphorus. It does, however, give rise to certain problems since its efficiency depends upon the correct regulation of va rious parameters, which are usually difficult to control.

The scope of the invention is to provide a method for manufacturing MOS devices making use of a gettering treatment which, compared to the treatment by deposition of phosphorus, is simpler and cheaper, as well as more easily controllable, so as to offer greater uniformity and repeatability of the electrical parameters of the devices obtained.

The method according to the invention is characterized by the fact that, after the gate oxidation step in the process for manufacturing MOS devices, the oxide on the back of the silicon wafers is chemically etched. Polycrystalline silicon is subsequently deposited both on the front of the wafers, to form the gate of the MOS devices, and on the back of them to form the "gettering" layer.

These and further features of the invention will be more clearly evident from the following description of a non-restrictive embodiment, with reference to the various figures of the accompanying drawings, in which:

Figs.1,2A-8A: show the various steps of a known process for manufacturing vertical current flow MOS devices, with gettering treatment by deposition of phosphorus;

Figs.1,2B-8B: show the various steps of a process for manufacturing vertical current flow MOS devices, with gettering treatment according to the invention;

Fig.9: shows the final structure of the MOS device as it appears both at the end of the known process referred to in Figs. 1, 2A-8A, and at the end of the process according to the invention, referred to in Figs. 1, 2B-8B;

Figs.10,11A,12A,13: show several steps of a known process for manufacturing a horizontal current flow MOS device with gettering treatment by deposition of phosphorus;

Figs.11B,12B: show steps replacing those relative to Figs. 11A and 12A, for carrying out the gettering treatment according to the invention.

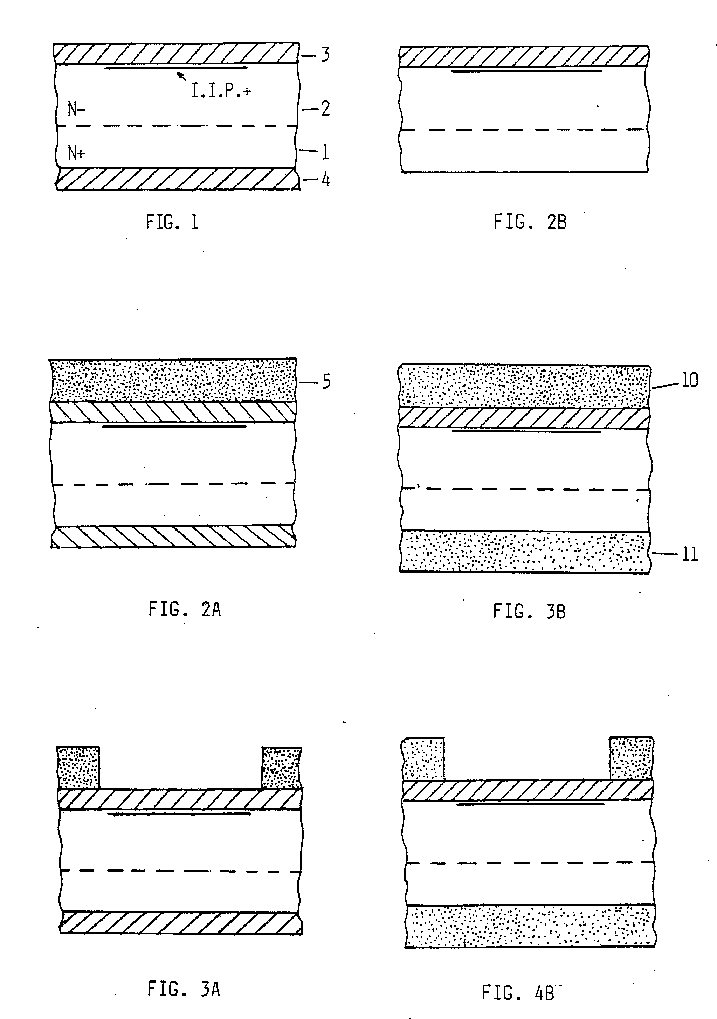

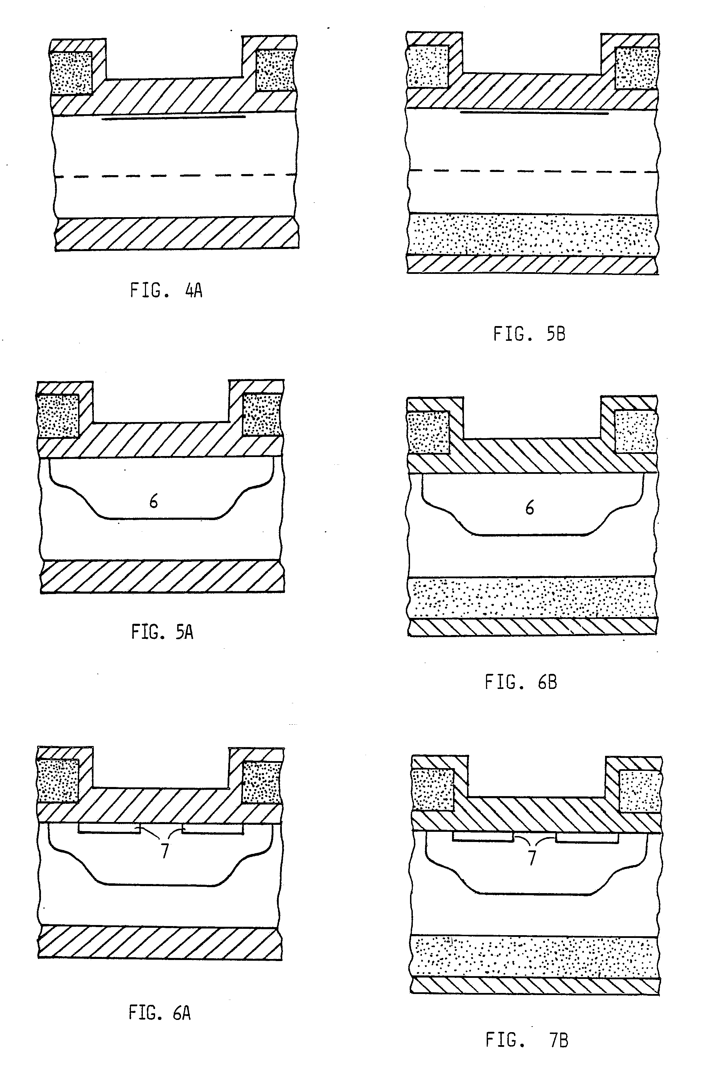

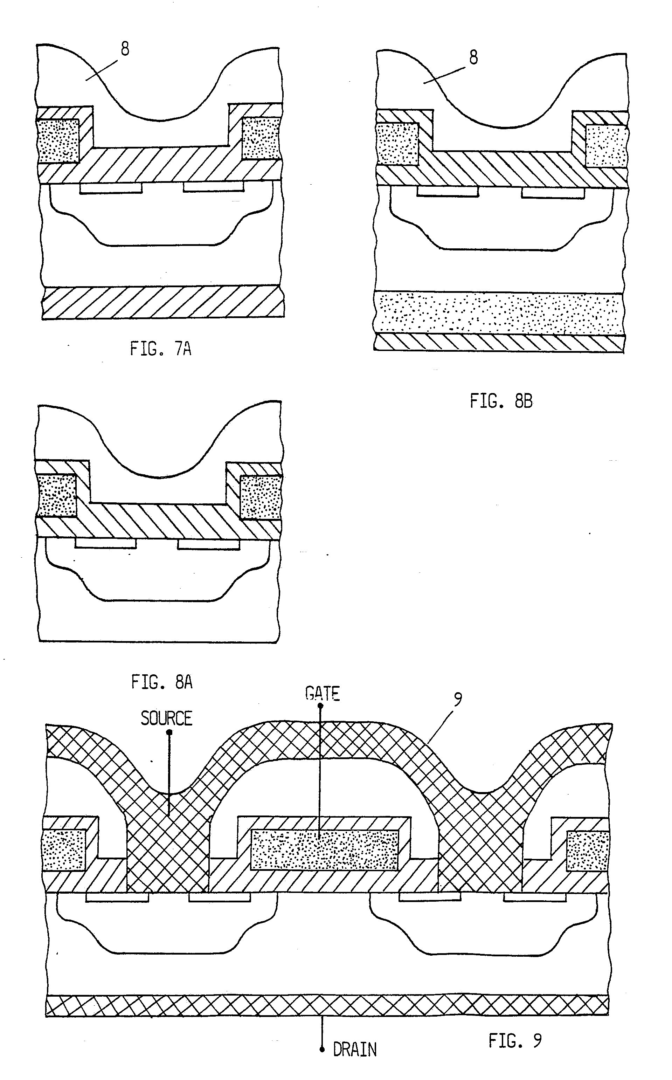

A known process for manufacturing vertical current flow MOS devices comprises the following consecutive steps:
- epitaxial growth of an N- type silicon layer 2 on an N+ type silicon substrate 1;
- P+ ion implantation (indicated by P+ I.I. in Fig.1) of the "deep body";
- (oxidation (also referred to as "gate oxidation"), carried out in a furnace, producing the layers of oxide 3 (gate) and 4 (both of approximately 800 A) on the front and on the back of the wafer; at the end of this step the wafer appears as shown in Fig. 1;
- deposition of a polycrystalline silicon layer (gate) on the front of the wafer only; this deposition on the front only is obtained by simply placing the wafers back to back in the vessel which holds them during the deposition; at the end of this step the wafer appears as shown in Fig.2A:
- aperture, by photoengraving, of a window in the polycrystalline silicon layer in correspondence with the "deep body" (Fig.3A);
- oxidation of the front and the back of the wafer (Fig. 4A);
- P- ion implantation of the "body" and subsequent diffusion with formation of the body region 6 (Fig.5A);
- aperture of windows on the front to create the source regions;
- diffusion of the source regions 7; at the end of this step the wafer appears as shown in Fig.6A;
- deposition of a P-Vapox intermediate dielectric layer 8 on the front of the wafer (Fig.7A);
- removal of the oxide on the back of the wafer by chemical etching (Fig.8A);
- gettering treatment by deposition of phosphorus on the back of the wafer (deposition from $POCl_3$ in furnace);
- thermal densification of the P-Vapox and "segregation annealing";
- aperture of windows on the front to enable the formation of source contacts;
- deposition of aluminium on the front by evaporation in order to obtain the source metal indicated by reference 9 in Fig.9;
- removal of the superfluous aluminium and definition of the contacts by photoengraving;
- final deposition of P-vapox on the front in order to isolate the previous metallization;
- phototechnical etching of the P-Vapox to enable the connection of the source and gate electrodes;
- lapping of the back to prepare for the subsequent deposition of the drain metal;
- deposition of the drain metal on the back.

Fig.9 shows (with exception of the final coating film of P-Vapox deposited on the source metal 9) the final structure of the device obtained.

The method according to the invention initially comprises the same operations as those described for the known method with reference to Fig. 1. It then continues according to the following consecutive steps:
- removal of the layer of oxide on the back of the wafer (Fig. (Fig.2B); - deposition of a layer of polycrystalline silicon on both the front and the back of the wafer (layers 10 and 11 of Fig.3B);
- aperture of a window, by photoengraving, in the polycrystalline layer on the front of the wafer in correspondence with the "deep body" (Fig.4B);
- oxidation of the front and the back of the wafer 5B);
- P- ion implantation of the "body" and subsequent diffusion with formation of the body region 6 (Fig.6B);
- aperture of windows on the front to form the source regions;
- diffusion of the source regions 7; at the end of this step the wafer appears as shown in Fig.7B;
- deposition of P-Vapox intermediate dielectric 8 on the front of the wafer (Fig.8B);
- thermal densification of the P-Vapox and "segregation annealing";
- aperture of windows on the front to enable the formation of the source contacts;
- deposition of aluminium on the front by evaporation to obtain the source metals, indicated by reference 9 in Fig.9;
- removal of the superfluous aluminium and definition of the contacts by photoengraving;
- final deposition of P-Vapox on the front to isolate the previous metallization;
- phototechnical etching of the P-Vapox to enable the connection of the source and gate electrodes;
- lapping of the back of the wafer to remove the layers of oxide and polycrystalline silicon, to prepare for the subsequent deposition of the drain metal;
- deposition of the drain metal on the back.

The structure of the device obtained at the end of the process according to the invention is the same (apart from the final film of P-Vapox covering the source metal 9) as that illustrated in Fig. 9.

It appears clear from the foregoing description that the manuacturing method according to the invention is extremely simple.

In fact, it substantially follows the known manufacturing process, with exception of the following variations:
- the initial "gate oxidation" of the wafer is immediately followed by the removal of the layer of silicon dioxide $SiO_2$ formed on the back of the wafer:
- the subsequent deposition of a layer of polycrystalline silicon, which in the known process is carried out only on the front, is carried out on both the front and the back of the wafer; this is obtained by means of the same procedure and equipment as in the known process with the addition of a simple variation consisting of positioning the wafers differently on the vessel on which they are placed during the deposition of the silicon: in fact, in order to obtain this deposition it is sufficient to dispose the wafers on the vessel evenly spaced apart and with their fronts all facing the same way, instead of disposed back to back as in the case of the known technique;
- the step of depositing phosphorus on the back of the wafer, which is envisaged in the known process, is omitted.

In addition to the advantages of extreme simplicity of the process, there are also considerable improvements in the electrical characteristics of the finished product.

In the MOS devices manufactured according to the invention there is, in fact, a considerable decrease in leakage current (for voltages equal to half the breakdown voltage there is a decrease in this current from approximately 4 $\mu$A to approximately 3 $\mu$A) and a considerable increase in lifetimes (from approximately 10 $\mu$sec to approximately 100 $\mu$sec).

The invention described with reference to N-channel MOS power devices also applies, with the necessary modifications known to the expert in the field, to P-channel MOS power devices.

It also applies to the case of horizontal current flow MOS devices.

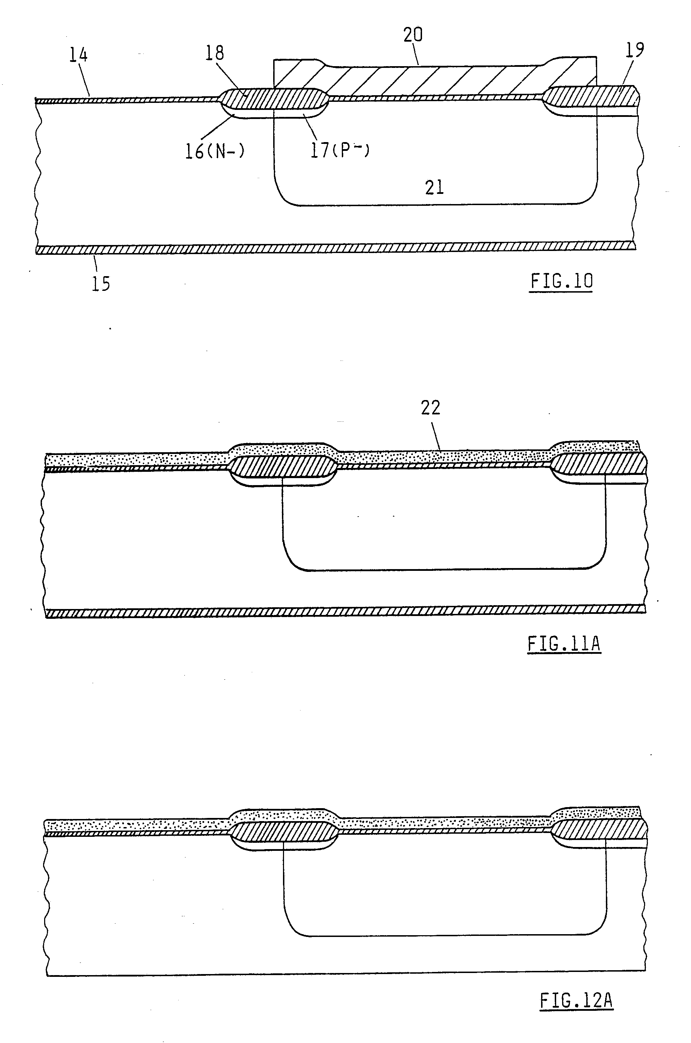

Taking as an example a complementary type horizontal current flow C-MOS device, a known manufacturing process initially consists of the epitaxial growth of an N- type silicon layer, on an N+ type silicon substrate, a first oxidation and the formation of a P region, called-well. Further operations of deposition, masking, implantation and oxidation are subsequently carried out (including a so-called "field" and "gate" oxidation), until the structure shown in Fig.10 is obtained. Said structure is relative to the step of ion implantation to obtain the P-channel. In the figure the following references are used to illustrate the various parts:

    14 and 15: layers of silicon dioxide SiO2;
    16 and 17: isolation zones;
    18 and 19: field oxide regions;
    20: layer of light-sensitive resin (photoresist);
    21: P-well region.

The front of the wafer of Fig. 10 is subjected to a process of ion implantation of the P-channel, followed by removal of the layer of photoresist and deposition on the front of the wafer of a layer of polycrystalline silicon (layer 22 of Fig.11A). The layer of oxide on the back of the substrate is subsequently removed, thereby obtaining the structure shown in Fig.12A. A deposition of phosphorus is then carried out (from POCl₃ in furnace) both on the front of the wafer to dope the gate polysilicon, and on the back of the wafer to carry out the gettering treatment.

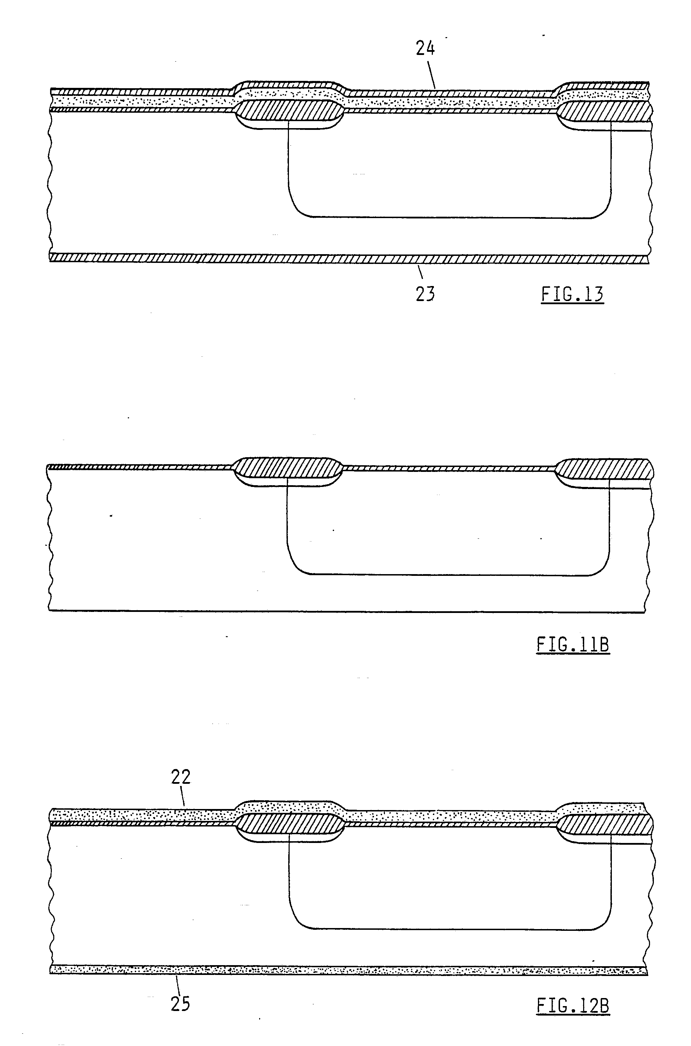

The structure obtained at the end of this step is shown in Fig.13, in which references 23 and 24 indicate two layers of silicon dioxide formed at the end of the treatment. The process continues with various steps, not shown in the figures, including notably those for the formation of the gate, source and drain regions, of the P+ regions of the wafer necessary for forming the P-channel MOS, and the final steps of masking the contacts and deposition of the metallization.

According to the invention, in place of the known treatment of gettering previously illustrated in relation to the C-MOS, it is sufficient to substitute the steps referred to in Figures 11A and 12A with those illustrated in Figs.11B and 12B. According to these latter steps, the process of ion implantation of the P-channel, previously mentioned with reference to Fig. 10, is followed by removal of the photoresist 20 and of the layer of oxide 15 on the back of the wafer (see Fig. 11B). This is then followed by deposition of polycrystalline silicon both on the front and on the back of the wafer (layers 22 and 25 of Fig. 12B ).

After this latter deposition, the process continues with the same steps as in the known technique subsequent to those of Fig. 12A, beginning with the deposition of phosphorus on the surfaces of the wafers which, however, in this case serves the sole purpose of doping the gate polysilicon on the front, since the gettering treatment is guaranteed by the previous deposition of polycrystalline silicon on the back of the wafer.

## Claims

1. Method for manufacturing vertical conduction or horizontal conduction MOS semiconductor devices, whose initial steps comprise epitaxial growth, on a substrate of silicon of a certain type of conductivity, of at least one layer of silicon of the same type of conductivity, ion implantation of the "deep body" or, respectively, of the "P-well", oxidation of the front (also referred to as "gate oxidation") and of the back of the wafer and subsequent deposition of a layer of polycrystalline silicon on the front of the wafer, destined to form the "gate" of the MOS devices, characterized by the fact that:
- immediately before the aforesaid deposition of polycrystalline silicon on the front of the wafer, the layer of oxide on the back of the wafer is removed;
- the aforesaid deposition of polycrystalline silicon on the front of the wafer is accompanied by the simultaneous deposition of polycrystalline silicon also on the back of the wafer.

2. Method as claimed in Claim 1, characterized by the fact that, in order to obtain the aforesaid deposition of polycrystalline silicon also on the back of the wafers, the wafers themselves are disposed on the vessel, which holds them during the deposition, evenly spaced apart and facing in the same direction.

3. Method for manufacturing vertical conduction MOS semiconductor devices as claimed in Claim 1 or 2, characterized by the fact that the final deposition of the drain metal on the back of the wafers is preceded by removal of the layers of polycrystalline silicon and of silicon dioxide on the back.

4. MOS devices obtained by a method according to any one of the previous claims.

FIG. 1

I.I.P.+

N−

N+

FIG. 2B

FIG. 2A

FIG. 3B

FIG. 3A

FIG. 4B

EP 0 373 723 A1

FIG. 4A

FIG. 5B

FIG. 5A

6

6

FIG. 6B

FIG. 6A

7

7

FIG. 7B

FIG. 7A

FIG. 8B

FIG. 8A

FIG. 9

FIG.10

FIG.11A

FIG.12A

FIG.13

FIG.11B

FIG.12B

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN, vol. 10, no. 363 (E-461)[2420], 5th Decembre 1986; & JP-A-61 159 741 (SONY CORP.) 19-07-1986 * Abstract; figures * | 1,4 | H 01 L 21/322 H 01 L 21/336 H 01 L 21/82 |
| A | EP-A-0 120 830 (MONSANTO CO.) * Page 17, line 30; page 9, lines 18-22 * | 1,2,4 | |
| A | EP-A-0 018 737 (BURROUGHS CORP.) * Page 13, lines 6-14; figure 4 * | 1,4 | |
| A | EP-A-0 092 540 (SHELL AUSTRIA AG) * Page 3, line 23 - page 6, line 33 * | 1,3,4 | |
| A | SOLID STATE TECHNOLOGY, vol. 26, no. 8, August 1983, pages 149-151; D.C. GUPTA et al.: "Effects of enhanced gettering on device performance" * Abstract: "Enhanced gettering" * | 1,3,4 | |
| A | EXTENDED ABSTRACTS, vol. 87-1, no. 1, Spring 1987, abstract no. 248, page 358; J.W. MEDERNACH et al.: "Extrinsic gettering for VLSI/ULSI processes * Whole document * | 1,4 | TECHNICAL FIELDS SEARCHED (Int. Cl.5) H 01 L |

The present search report has been drawn up for all claims

| Place of search | Date of completion of the search | Examiner |
|---|---|---|
| THE HAGUE | 19-03-1990 | GELEBART J.F.M. |